# DEMANDE DE BREVET EUROPEEN

(11) **EP 2 685 504 A1**
(43) Date de publication de la demande: **15.01.2014**
(21) Numéro de dépôt: 13174928.5
(22) Date de dépôt: 03.07.2013
(51) Int. Cl.: H01L 29/739, H01L 21/331, H01L 29/165

(54) **Transistor à effet tunnel**

(30) Priorité: 11.07.2012 FR 1256686
(71) Demandeur: Commissariat à l'Énergie Atomique et aux Énergies Alternatives, 75015 Paris (FR); CENTRE NATIONAL DE LA RECHERCHE SCIENTIFIQUE, 75016 Paris Cedex (FR)
(72) Inventeur: Le Royer, Cyrille, 38210 Tullins-Fures (FR); Cristoloveanu, Sorin, 38170 Seyssinet-Pariset (FR); Wan, Jing, 38000 Grenoble (FR); Zaslavsky, Alexander, Rhode Island, 02906 (US)
(74) Mandataire: Ahner, Philippe

(57) **Abrégé**

L'invention concerne un transistor à effet tunnel (TFET) dont la région de drain (140, 440, 540) comporte une première zone dopée (111, 411, 511) selon un dopage d'un premier type (N+), et une deuxième zone dopée (112, 412, 512) selon un dopage d'un deuxième type (P) formant avec la première zone une jonction (PN+). On obtient ainsi un fort courant à l'état passant (I_{ON}) par amplification bipolaire.

## Description

### DOMAINE TECHNIQUE

L'invention concerne le domaine de la microélectronique et celui des transistors, en particulier celui des transistors à effet tunnel.

Elle prévoit la mise en oeuvre d'une structure de transistor à effet tunnel améliorée.

### ART ANTÉRIEUR

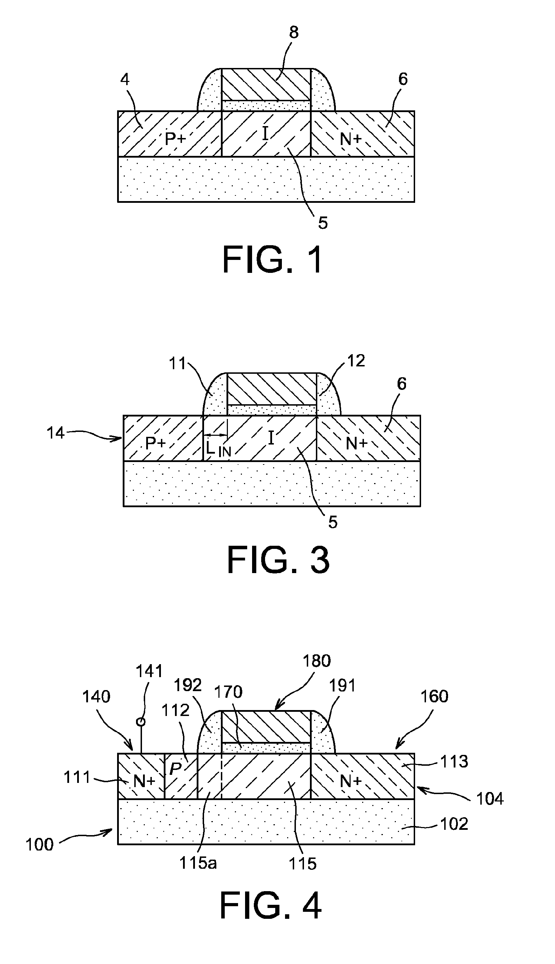

La figure 1 illustre un dispositif de transistor tunnel ou TFET (TFET pour « Tunnel Field Effect Transistor » ou transistor tunnel à effet de champ) selon l'art antérieur. Sa structure est semblable à celle d'un transistor MOSFET classique, mais ce transistor est doté de part et d'autre de son électrode de grille 8, d'une zone 4 dopée P+, et d'une zone 6 dopée N+, les zones dopées 4 et 6 étant séparées par une zone semi-conductrice 5 non dopée formant une région de canal tandis que les zones dopées 4 et 6 sont susceptibles de jouer le rôle de région de source ou de drain en fonction de la manière dont elles sont polarisées. Les zones dopées 4 et 6 et la zone semi-conductrice 5 non dopée forment une diode de type PIN contrôlée par l'électrode de grille 8.

Le transistor peut être prévu pour fonctionner comme un transistor de type P, la région dopée P+ étant dans ce cas utilisée comme région de drain et polarisée à l'aide d'un potentiel négatif, tandis que la région dopée N+ est utilisée comme région de source et mise à la masse.

Lorsque le transistor est prévu pour fonctionner comme un transistor de type N, une configuration de polarisation opposée est mise en oeuvre. La région dopée P+ est utilisée comme région de source et peut être mise à la masse, tandis que la région dopée N+ est utilisée comme région de drain et polarisée à l'aide d'un potentiel positif.

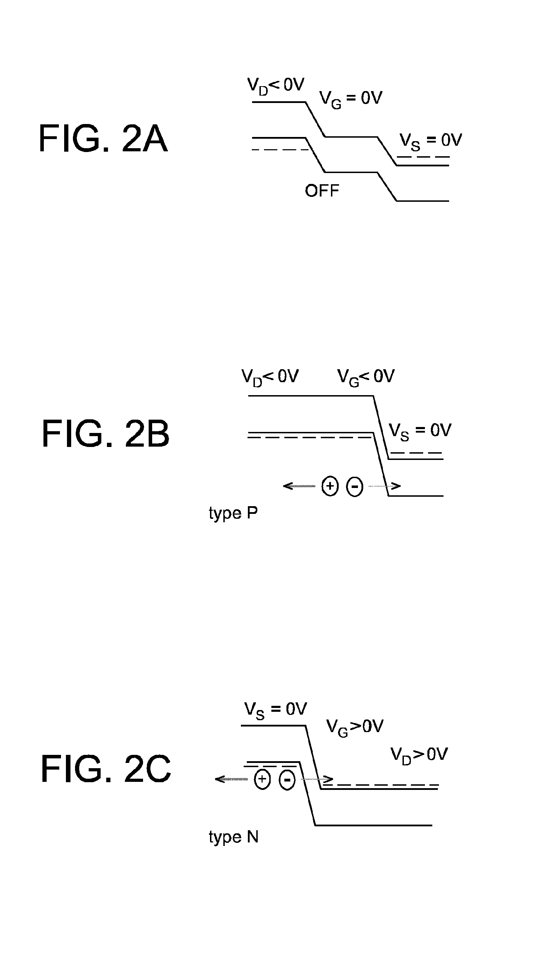

Les figures 2A, 2B, 2C représentent des diagrammes de bande, respectivement, d'un transistor à effet tunnel polarisé de manière à être mis à l'état bloqué, d'un transistor à effet tunnel de type P mis à l'état passant, d'un transistor à effet tunnel de type N mis à l'état passant.

Les transistors à effet tunnel sont particulièrement avantageux pour des applications nécessitant une rapidité de commutation et mettant en oeuvre une faible consommation.

Les transistors à effet tunnel subissent par ailleurs moins les effets dits de « canal court » que les transistors MOS.

Un tel type de transistor peut cependant poser des problèmes de courant de fuite.

Pour résoudre un tel problème, une variante d'agencement telle que décrite dans le document SOI TFETs : « Suppression of Ambipolar Laeakage and Low-Frequency Noise Behavîour », Wan et al., IEEE 2010 et illustrée sur la figure 3 peut être prévue.

Pour cette variante, le transistor TFET comporte une zone 6 dopée N+ et une autre zone 14 dopée P+, agencées de part et d'autre de la grille 8, de manière asymétrique par rapport à cette dernière.

La zone 6 dopée N+ s'étend sous un espaceur 12 formé contre la grille 8 du transistor et est séparée de la zone 14 dopée P+ par une zone semi-conductrice 5 non-dopée. La zone 14 dopée P+ ne s'étend pas sous l'autre espaceur isolant 11 formé contre la grille 8, la zone semi-conductrice 5 non-dopée comportant une portion de longueur Lᵢₙ sous cet autre espaceur isolant 11.

Lorsque la zone 14 dopée P+ forme une région de drain, la disposition de la zone non-dopée sous l'espaceur 11 permet de réduire les courants de fuite au niveau du drain.

Avec une telle structure, le niveau de courant I_{ON} à l'état passant, reste inférieur à celui obtenu avec une structure de transistor MOS classique.

Le document « Vertical Tunnel Field Effect Transistor », Kumar et al., IEEE 2004, présente quant à lui une structure verticale de transistor à effet tunnel.

Il se pose le problème de trouver une nouvelle structure de transistor présentant les avantages d'une structure de type TFET, tout en ayant un niveau de courant I_{ON} à l'état passant plus élevé.

### EXPOSÉ DE L'INVENTION

La présente invention concerne un dispositif ayant une structure de transistor à effet tunnel ou TFET et doté d'une électrode formée d'une jonction.

La présente invention concerne un transistor, en particulier à effet tunnel, doté de régions de source et de drain, ainsi qu'au moins une grille, une région donnée parmi lesdites régions de source et de drain comportant une première zone dopée selon un dopage d'un premier type, ladite région donnée comportant en outre une deuxième zone dopée selon un dopage d'un deuxième type et formant une jonction avec ladite première zone dopée.

Par dopage de types différents on entend que le dopage du premier type, consiste à mettre en oeuvre un excès d'un premier type de porteurs de charge, par exemple d'électrons (dopage de type N ou N+), tandis que le dopage du deuxième type consiste à mettre en oeuvre un excès d'un deuxième type de porteurs de charge, par exemple de trous (dopage de type P ou P+).

La première zone peut être par exemple dopée N+, tandis que la deuxième zone peut être dopée P, de manière à former une jonction N+P.

L'autre région parmi les régions de source et de drain comporte une troisième zone dopée selon un dopage de type différent de celui de ladite deuxième zone dopée. La première zone dopée peut être par exemple dopée N+. La troisième zone peut être ainsi dopée selon un dopage du même type que celui de la première zone dopée.

Lesdites première, deuxième et troisième zones dopées permettent de mettre en oeuvre une amplification bipolaire du courant I_{ON} du transistor.

La deuxième zone dopée et la troisième zone dopée peuvent être séparées par une zone semi-conductrice non-dopée ou faiblement dopée dans laquelle une région de canal du transistor est prévue.

Par zone faiblement dopée, on entend tout au long de la présente description que la concentration en dopants de cette zone est au moins inférieure à 10¹⁷ cm⁻³.

Selon une possibilité avantageuse d'agencement, la première zone dopée et la deuxième zone dopée peuvent être superposées ou empilées.

Le transistor peut comprendre en outre : un premier espaceur isolant et un deuxième espaceur isolant disposés contre l'électrode de grille.

La troisième zone dopée peut être agencée de manière à avoir un prolongement sous le deuxième espaceur, ladite zone semi-conductrice non-dopée ou faiblement dopée étant quant à elle placée contre ladite deuxième zone dopée, et s'étend en regard de la grille ainsi que sous le premier espaceur.

Un tel agencement permet de réduire les courants de fuite.

Selon une possibilité de mise en oeuvre, ladite autre région, parmi les régions de source et de drain peut comporter une quatrième zone dopée ayant un dopage de type différent de celui de ladite deuxième zone dopée et du même type que celui de la troisième zone dopée, la quatrième zone dopée étant en contact avec la troisième zone dopée et disposée en regard de ladite région de canal du transistor et de ladite région donnée, ladite zone semi-conductrice non-dopée ou faiblement dopée séparant ladite quatrième zone dopée de ladite deuxième zone dopée.

Dans le cas où la troisième zone dopée appartient à une région de source du transistor, cette quatrième zone dopée peut servir de zone de source enterrée.

Un tel agencement peut permettre de réduire la résistance au flux de porteurs majoritaires.

Le transistor peut être également prévu de sorte que la première zone dopée est à base d'un premier matériau semi-conducteur, et que la deuxième zone dopée est à base d'un deuxième matériau semi-conducteur, le deuxième matériau semi-conducteur ayant un gap plus faible que le premier matériau semi-conducteur.

Une hétérojonction est ainsi formée et permet d'obtenir un courant de porteurs majoritaires élevé tout en maintenant un courant de porteurs minoritaires faible, ce en réalisant une amplification bipolaire de courant tunnel.

La grille et la deuxième zone dopée peuvent reposer sur une couche à base du deuxième matériau semi-conducteur.

Un matériau semi-conducteur de faible gap peut être ainsi choisi pour former la région de canal.

Selon une variante d'agencement du transistor, la première zone dopée et la deuxième zone dopée sont superposées, les régions de drain et de source étant également superposées, ladite autre région comportant, de part et d'autre de l'électrode de grille, la troisième zone dopée et une quatrième zone dopée selon un dopage du même type que celui de ladite troisième zone dopée, la quatrième zone dopée et ladite troisième zone dopée reposant sur une zone semi-conductrice non-dopée ou faiblement dopée et étant séparés de la deuxième zone dopée par cette zone semi-conductrice non-dopée ou faiblement dopée.

Selon une autre variante d'agencement du transistor, la première zone dopée et la deuxième zone dopée sont superposées, les régions de drain et de source étant également superposées, une zone semi-conductrice non-dopée ou faiblement dopée reposant sur ladite deuxième zone dopée et sépare ladite deuxième zone dopée de ladite troisième zone dopée, ladite troisième zone dopée reposant sur la zone semi-conductrice non-dopée, l'électrode de grille étant disposée autour d'une portion de ladite zone semi-conductrice non-dopée.

Selon une autre variante d'agencement, le transistor à effet tunnel peut être mis en oeuvre avec une structure double grille.

Selon cette autre variante du transistor, la première zone dopée et la deuxième zone dopée sont superposées, les régions de drain et de source étant également superposées, une zone semi-conductrice non-dopée ou faiblement dopée reposant sur ladite deuxième zone dopée et sépare ladite deuxième zone dopée de ladite troisième zone dopée, ladite troisième zone dopée reposant sur la zone semi-conductrice non-dopée, une première électrode de grille étant disposée contre une première portion de ladite zone semi-conductrice non-dopée, tandis qu'une autre électrode de grille indépendante de ladite première électrode de grille est disposée contre une deuxième portion de ladite zone semi-conductrice non-dopée située en regard de la première portion.

Le transistor peut ainsi comporter deux électrodes polarisées de manière indépendante l'une de l'autre.

Cela peut permettre de mettre en oeuvre un transistor tunnel de très faible longueur de grille.

L'invention prévoit un dispositif microélectronique comprenant un ou plusieurs transistors tels que définis précédemment.

La présente invention concerne également un procédé de fabrication d'un transistor tel que défini précédemment.

La présente invention concerne en particulier un procédé de réalisation d'un transistor comprenant des étapes de : formation d'une région donnée de source ou de drain comportant une zone dopée selon un dopage d'un premier type reposant sur une deuxième zone dopée selon un dopage d'un deuxième type et réalisant une jonction avec ladite première zone dopée, et d'une autre région de drain ou de source, comportant une troisième zone dopée selon un dopage de type différent de celui de ladite deuxième zone dopée.

Le procédé peut comprendre en outre : préalablement à l'étape de formation de ladite région donnée, des étapes de :
- formation au moins partielle d'une grille, puis
- formation de la région donnée par dépôt de part et d'autre de la grille d'une couche semi-conductrice dopée selon le dopage du deuxième type, puis dépôt de part et d'autre de la grille d'une autre couche semi-conductrice dopée selon le dopage du premier type.

Le procédé peut comprendre après l'étape de formation de la région donnée, une étape consistant à implanter localement d'un seul côté de la grille de manière à modifier le dopage de ladite couche semi-conductrice dopée et de ladite autre couche semi-conductrice dopée.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre une structure de transistor à effet tunnel,
- les figures 2A, 2B, 2C représentent des diagrammes de bande d'une structure de transistor à effet tunnel,
- la figure 3 illustre une variante de structure de transistor à effet tunnel,
- la figure 4 illustre un premier exemple de transistor à effet tunnel suivant l'invention doté d'une région de drain comportant des zones dopées accolées de types différents et formant une jonction,
- la figure 5 illustre un deuxième exemple de structure de transistor à effet tunnel suivant l'invention doté d'une région de drain comportant des zones dopées superposées de types différents et formant une jonction,
- la figure 6 illustre un troisième exemple de structure de transistor à effet tunnel suivant l'invention, doté d'une région de drain comportant des zones dopées superposées de types différents et formant une jonction, le transistor comportant en outre une région de source enterrée passant sous la région de canal et qui s'étend en regard de la région de drain ;
- les figures 7A et 7B représentent des résultats de simulations de densité de porteurs de charges au sein d'un transistor à effet tunnel suivant l'invention,
- les figures 8, 9, 10, 11 illustrent des caractéristiques électriques de fonctionnement de transistor(s) à effet tunnel mis en oeuvre suivant l'invention,
- les figures 12A-12H illustrent un exemple de procédé de fabrication d'un transistor à effet tunnel suivant l'invention,
- la figure 13 illustre un quatrième exemple d'un transistor à effet tunnel avec amplification bipolaire suivant l'invention, doté de régions de source, de canal et de drain superposées, la région de drain comportant des zones dopées superposées de types différents et formant une jonction,
- la figure 14 illustre des caractéristiques électriques de fonctionnement d'un transistor à effet tunnel du type du quatrième exemple de transistor à effet tunnel suivant l'invention,
- les figures 15A et 15B représentent des résultats de simulations de densité de porteurs de charges au sein d'un transistor à effet tunnel du type du type du quatrième exemple de transistor à effet tunnel suivant l'invention,
- la figure 16 illustre un cinquième exemple de transistor TFET doté de régions de source, de canal et de drain superposées, la région de drain comportant des zones dopées superposées de types différents et formant une jonction,
- la figure 17 illustre des caractéristiques électriques de fonctionnement d'un transistor à effet tunnel du type dudit cinquième exemple de transistor à effet tunnel,
- les figures 18A, 18B, représentent des résultats de simulations de densité de porteurs de charges au sein d'un transistor à effet tunnel du type dudit cinquième exemple de transistor à effet tunnel,
- la figure 19 illustre une sixième variante de transistor TFET doté d'une structure double-grille,
- la figure 20 représente des résultats de simulations de densité de porteurs de charges au sein d'une telle structure de transistor à effet tunnel du type dudit sixième exemple de transistor.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un premier exemple de dispositif microélectronique suivant l'invention, comprenant un transistor à effet tunnel formé sur un substrat va à présent être donné en liaison avec la figure 4.

Le substrat 100 peut être par exemple de type semi-conducteur sur isolant tel qu'un substrat SOI (SOI pour « Silicon On Insulator ») et formé d'une couche de support (non représentée) semi-conductrice, par exemple à base de silicium, recouverte d'une couche isolante 102, par exemple à base de SiO₂, elle-même recouverte par une couche 104 à base d'un matériau semi-conducteur tel que par exemple du silicium, et dans laquelle une zone de canal du transistor, est prévue.

En regard de la zone de canal, une zone de diélectrique 170 de grille et une électrode de grille 180 formée sur cette zone diélectrique 170 reposent sur la couche semi conductrice 104.

Des régions de drain 140 et de source 160 sont disposées de part et d'autre de la grille 180.

La région de drain 140 comporte une première zone dopée 111 formée dans la couche semi-conductrice 104 et une deuxième zone dopée 112 également formée dans la fine couche semi conductrice 104 et accolée à la première zone dopée 111.

Le dopage de la première zone 111 est élevé et d'un type donné, par exemple de type N+, tandis que celui de la deuxième zone dopée 112 peut être d'un type différent et selon une concentration moins importante que celle du dopage de la première zone 111. La deuxième zone 112 peut être ainsi par exemple dopée P.

Une jonction, dans cet exemple de type N+P, est ainsi réalisée au niveau de la région de drain 140 du transistor.

La première zone dopée 111 est celle sur laquelle une prise de contact 141 est réalisée afin de polariser la région de drain 140 du transistor.

Une troisième zone dopée 113 est prévue au niveau de la région de source 160 et peut être également formée dans la couche semi-conductrice 104.

Le dopage de la troisième zone 113 peut-être élevé et différent de celui de la deuxième zone dopée 112. Le dopage de la troisième zone 113 peut-être du même type que celui de la première zone dopée 111, par exemple un dopage de type N+. Dans cet exemple de réalisation, la troisième zone dopée 113 s'étend sous un premier espaceur isolant 191 disposé contre l'électrode de grille 180, jusqu'à une région située à l'aplomb ou proche d'une zone de contact entre cet espaceur isolant 191 et l'électrode de grille 180. La troisième zone dopée 113 appartenant à la région de source 160 et la deuxième zone dopée 112 de la région de drain 140 sont séparées l'une de l'autre par une zone 115 de la couche conductrice 104 qui peut être non-dopée ou faiblement dopée, c'est-à-dire selon une concentration inférieure à 10¹⁷ cm⁻³.

Cette zone 115 s'étend dans cet exemple, de la région située à l'aplomb ou à proximité de l'aplomb de la zone de contact entre le premier espaceur isolant 191 et la grille 180, jusqu'à ladite deuxième zone dopée 112. La zone 115 s'étend sous un deuxième espaceur isolant 192. La frontière entre cette zone 115 et la deuxième zone dopée 112 peut être située au delà du deuxième espaceur 192, de sorte que le deuxième espaceur 192 repose entièrement sur une portion 115a de la zone 115 non-dopée ou faiblement dopée.

Par rapport à une structure de transistor tunnel telle qu'illustrée sur les figures 1A ou 1B, le transistor de la figure 4 comporte une zone dopée 111 N+ supplémentaire sur laquelle la prise de contact 141 est réalisée a été prévue. Cette zone supplémentaire permet de mettre en oeuvre une amplification bipolaire de courant tunnel, résultant en un courant à l'état I_{ON} plus fort que dans les transistors à effet tunnel classiques tout en ayant une pente sous seuil inférieure à 60 mV/décade dans une gamme de courant de drain plus importante.

Le transistor peut être polarisé par exemple de telle sorte qu'un potentiel V_{D} < 0V est appliqué sur la région de drain 140 du transistor, qu'un potentiel V_{G} < 0V est appliqué sur sa grille 180 et qu'un potentiel V_{S} = 0V est appliqué sur sa région de source 160.

Des trous générés par effet tunnel dans la jonction entre la zone 113 dopée N+ de la région de source 160 et le canal non-dopé ou faiblement dopé sont dirigés vers la région de drain 140. Cela augmente la polarisation directe de la jonction N+P de la région de drain 140. Cela entraine, une injection supplémentaire d'électrons (qui sont dans cet exemple de polarisation les porteurs de charges majoritaires) de la première zone 111 dopée N+ de la région de drain 140 vers la deuxième zone 112 dopée P de la région de drain 140 et sont ensuite dirigés vers la région de source 160.

Un tel agencement permet de réaliser une amplification bipolaire du courant généré par effet tunnel, et d'obtenir ainsi un courant plus important qu'avec les transistors à effet tunnel suivant l'art antérieur, notamment d'au moins 1 mA/µm tout en préservant, comme dans les transistors à effet tunnel suivant l'art antérieur, de bonnes propriétés de commutation entre ses états (passant ou bloqué).

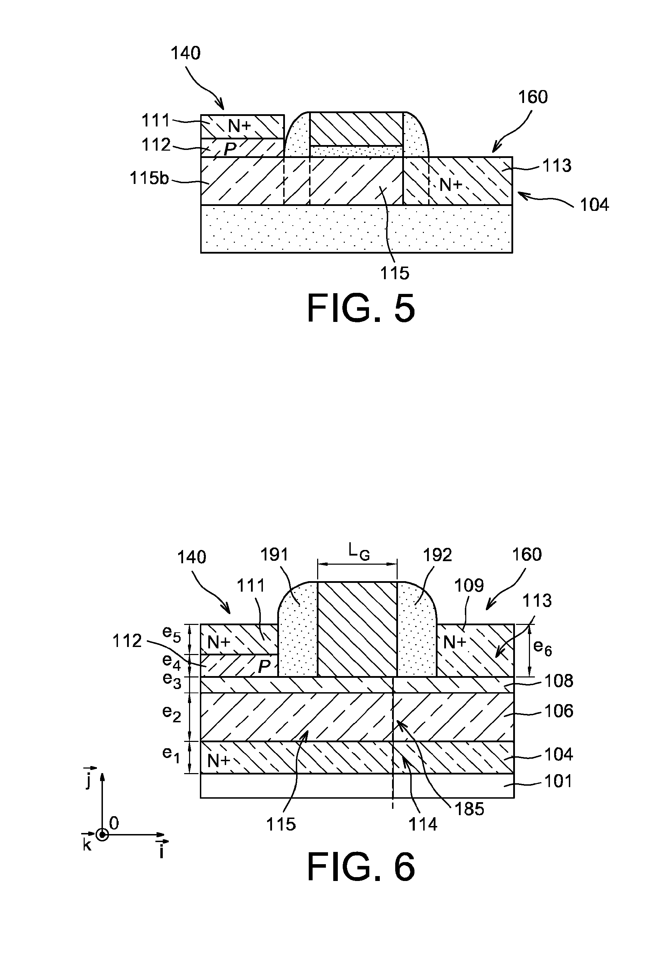

Un deuxième exemple de structure de transistor est donné sur la figure 5.

L'agencement de la région de drain 140 diffère de celui précédemment décrit, notamment en ce que la première zone dopée 111 repose sur et est en contact avec la deuxième zone dopée 112. Les zones dopées 111, 112 formant une jonction N+P sont ainsi empilées sur la couche semi-conductrice 104.

Un tel agencement peut être plus aisé à mettre en oeuvre que le précédent et en particulier permettre plus aisément de prévoir des zones 111 et 112 à base de matériaux semi-conducteurs différents.

Dans cet exemple de réalisation, la zone 115 non-dopée ou faiblement dopée de la couche semi-conductrice 104, prévue entre la deuxième zone dopée 112 et la troisième zone dopée 113 dans le chemin des porteurs de charge circulant entre la région de drain 140 et la région de source 160, s'étend cette fois également sous la région de drain 140. La deuxième zone dopée 112 peut ainsi reposer sur et être en contact avec une portion 115b de la zone semi-conductrice non dopée ou faiblement dopée.

Une mise en oeuvre particulière prévoit de réaliser la première zone dopée 111 dans une couche à base d'un premier matériau semi-conducteur, par exemple tel que du Si et la deuxième zone dopée 112 dans une couche à base d'un deuxième matériau semi-conducteur, différent du premier matériau, et de préférence de gap plus faible, par exemple tel que du Si₁₋ₓGeₓ.

La mise en oeuvre d'une première zone 111 dopée N+ à base de Si et d'une deuxième zone 112 dopée P à base de Si₁₋ₓGeₓ permet d'obtenir un courant en électrons important même lorsque la conduction de trous générés par effet tunnel reste faible.

Avec un tel agencement, on peut amplifier le courant tunnel tout en conservant de bonnes propriétés de commutation de la jonction à effet tunnel.

D'autres associations de matériaux semi-conducteurs peuvent être prévues pour mettre en oeuvre un transistor tel que décrit précédemment en liaison avec les figures 4 et 5. Des matériaux tels que de l'InGaAs, de l'InGaP, du AlGaAs et GaAs peuvent être en particulier utilisés, avec la zone 112 ayant un gap plus faible que la zone 111.

Un troisième exemple de transistor à effet tunnel est donné sur la figure 6.

L'électrode de grille 180 de ce transistor repose sur un empilement de couches semi-conductrices 108, 106, 104.

Le dispositif comporte également une quatrième zone 114 fortement dopée selon un dopage du même type que celui de la troisième zone dopée 113, par exemple de type N+. La quatrième zone 114 dopée est en contact avec la troisième zone dopée 113 et s'étend sous et en regard de la région de source 160, de la région de canal, et de la région de drain 140. La quatrième zone dopée 114 peut être ainsi un prolongement de la région de source 160 du transistor alors qualifiée de source « enterrée ».

La quatrième zone dopée 114 peut être réalisée par exemple dans la couche 104 du substrat SOI. Cette quatrième zone dopée 114 peut permettre d'améliorer la circulation des électrons entre la région de source 160 et la région de drain 140.

Sur la couche semi-conductrice 104 repose une couche semi-conductrice 106 dite « tampon » dans la quelle la troisième zone dopée 113 est partiellement réalisée. La couche semi-conductrice 106 tampon comporte une zone non-dopée ou faiblement dopée qui s'étend sous l'électrode de grille 180 ainsi que sous la région de drain 140.

Sur cette couche semi-conductrice 106 tampon repose une couche semi-conductrice 108 dite « tunnel » dans la quelle la troisième zone dopée 113 est au moins partiellement réalisée, et comportant une zone non-dopée ou faiblement dopée qui s'étend sous l'électrode de grille 180 ainsi que sous la région de drain 140. La couche semi-conductrice 108 tunnel peut être à base d'un matériau semi-conducteur à faible gap tel que du Si₁₋ₓGeₓ afin d'augmenter le taux d'injection tunnel.

Ainsi, cette couche semi-conductrice 108 tunnel peut être à base du même matériau semi-conducteur que celui d'une couche dans laquelle la deuxième zone dopée 112 de la région de drain 140 est réalisée. Prévoir la couche semi-conductrice zone 108 à base de SiGe permet de favoriser l'effet tunnel.

En variante, les exemples de dispositifs décrits précédemment peuvent être réalisés sur un substrat massif communément appelé « bulk », par exemple à base de Si ou bien à base d'un matériau semi-conducteur III-V.

Un exemple détaillé de réalisation d'un transistor à effet tunnel du type décrit précédemment, va à présent être donné.

La région de drain 140 de ce transistor comporte une première zone 111 à base de silicium fortement dopé N+ avec une concentration supérieure à 10¹⁹ cm⁻³ et une épaisseur e₅ (l'épaisseur étant une dimension mesurée dans une direction parallèle au vecteur *̅j̅*̅ repère orthogonal [o; *̅i̅*̅; *̅j̅*̅; *̅k̅*̅]) donné sur la figure 6) comprise entre 10 nm et 100 nm, par exemple de l'ordre de 20 nm.

Sous et en contact avec la première zone dopée 111, la région de drain 140 comporte une deuxième zone 112 à base Si₁₋ₓGeₓ, dopée selon un dopage de type P avec une concentration par exemple comprise entre 5x10¹⁸ cm⁻³ et 5x10¹⁹cm⁻³, ou par exemple de l'ordre de 2x10¹⁹cm⁻³. Une telle gamme de concentration permet d'obtenir un gain d'amplification bipolaire important.

La deuxième zone dopée 112 a, quant à elle, une épaisseur e₄ comprise par exemple entre 5 nm et 50 nm, par exemple de l'ordre de 15 nm. Une zone dopée 112 prévue dans une telle épaisseur e₄ permet d'améliorer le gain d'amplification tout en limitant les délais de propagation et en évitant des effets communément appelés de perçage (ou « punch-through »). La teneur x en Germanium de la deuxième zone 112 peut être comprise entre 0% et 70%, par exemple de l'ordre de 30%.

L'électrode de grille 180 a une longueur ou dimension critique L_{G} comprise entre 10 nm et 1000 nm par exemple de l'ordre de 50 nm ou de 25 nm et repose sur un oxyde de grille qui peut être par exemple formée d'une couche de matériau diélectrique d'épaisseur par exemple de l'ordre de 1 nm. Par dimension critique on entend tout au long de la présente description, la plus petite dimension d'une zone ou d'un bloc hormis son épaisseur (la dimension critique L_{G} étant dans l'exemple de la figure 6 une dimension mesurée dans une direction parallèle au vecteur *̅i̅*̅ du repère orthogonal [o; *̅i̅*̅; *̅j̅*̅; *̅k̅*̅]).

La grille 180 du transistor repose sur une couche semi-conductrice 108 tunnel intrinsèque non-dopée ou faiblement dopée, c'est-à-dire selon un dopage de type N de concentration inférieure à 10¹⁷ cm⁻³ à un dopage de type P de concentration inférieure à 10¹⁷ cm⁻³.

La couche semi-conductrice 108 tunnel est à base de Si₁₋ₓGeₓ et à une teneur x en Ge comprise entre 0% et 60%, par exemple de l'ordre de 30%. Cette couche semi-conductrice 108 tunnel a également une épaisseur e₃ comprise entre 5 nm et 50 nm, ou par exemple de l'ordre de 10 nm.

La couche semi-conductrice 108 tunnel repose sur une couche semi-conductrice 106 tampon permettant notamment d'éviter un phénomène tunnel parasite entre la deuxième zone dopée 112 et une quatrième zone dopée 114 formée dans une couche semi-conductrice sur laquelle repose la couche semi-conductrice 106 tampon, la quatrième zone dopée 114 étant en contact avec la troisième zone dopée 113 et dopée selon un dopage de même type que celui de la troisième zone dopée 113, par exemple un dopage N+.

La couche semi-conductrice 106 tampon a une épaisseur e₂ comprise entre 10 nm et 100 nm, ou par exemple de l'ordre de 40 nm et est à base d'un matériau semi-conducteur intrinsèque non-dopé ou faiblement dopé, c'est-à-dire selon un dopage de type N de concentration de 10¹⁷ cm⁻³ à un dopage de type P de concentration 10¹⁷ cm⁻³.

La couche semi-conductrice 106 tampon repose sur une couche semi-conductrice 104 dans laquelle la quatrième zone dopée 114 est formée et permet de créer un chemin de faible résistivité pour des électrons circulant entre la région de drain 140 et la région de source 160 du transistor. Cette zone 114 peut-être fortement dopée N+ selon une concentration supérieure à 10¹⁹ cm⁻³ et permet d'obtenir un courant à l'état passant important. La quatrième zone dopée 114 a une épaisseur e₁ comprise entre 5 nm et 1000 nm par exemple de l'ordre de 20 nm et forme une région de source enterrée qui s'étend contre une zone semi-conductrice non-dopée ou faiblement dopée 115 et la troisième zone dopée 113.

La troisième zone dopée 113 comprend une région semi conductrice à base de silicium reposant sur la couche tunnel 108 ayant une épaisseur e₆ comprise par exemple entre 10 nm et 100 nm par exemple, de l'ordre de 35 nm.

La frontière 185 entre cette troisième zone dopée 113 et la région de canal peut être décalée par rapport à la frontière entre l'espaceur isolant 192 et la grille 180. Ce décalage est prévu de sorte qu'une portion de la troisième zone dopée 113 est située en regard de la grille 180. Ce dépassement peut être par exemple de l'ordre de 2 nm.

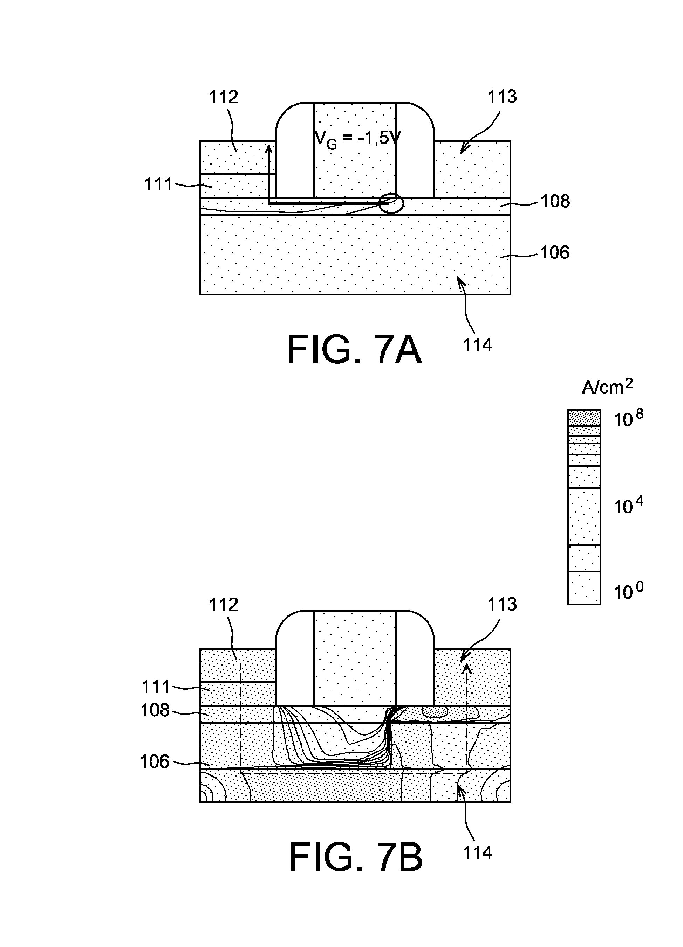

La figure 7A représente une densité de trous au sein d'un transistor à effet tunnel tel que décrit précédemment, pour des conditions de polarisation telles que le potentiel de drain V_{D} = -1.5V, le potentiel de grille V_{G} = -1.5V, le potentiel de source V_{S} = 0V. Cette figure montre un flux de trous circulant de la zone de canal vers la deuxième zone dopée 112 de la région de drain puis la première zone dopée 111.

La figure 7B représente quant à elle une densité d'électrons au sein de ce transistor. Des électrons circulent de la deuxième zone dopée 112 vers la quatrième zone dopée 114 de source enterrée. Ces figures 7A, 7B montrent qu'avec un tel transistor, un courant d'électrons important peut être obtenu tout en maintenant un faible courant de trous.

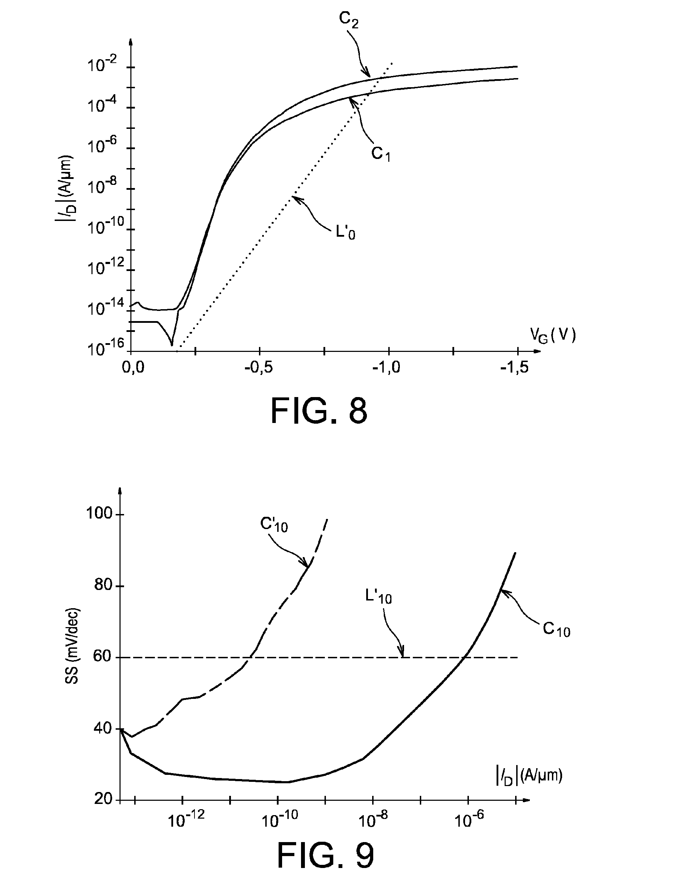

D'autres résultats de simulations de performances électriques d'un tel transistor obtenus à l'aide d'un outil de simulation par exemple de type SENTAURUS, sont illustrées sur les figures 8, 9, 10, 11.

La figure 8 donne des courbes C₁, C₂, d'évolution de courant de drain I_{D} en fonction d'un potentiel de grille du transistor du type de la figure 5 ayant une longueur de grille L_{G} de 50 nm et comportant une couche tunnel 108 à base de Si_{0.7}Ge_{0.3}, l'évolution de I_{D} étant à potentiel de drain V_{D} constant, avec V_{D} = -1V pour la première courbe C₁ et V_{D} = -1,5V pour la deuxième courbe C₂. A titre de comparaison, un seuil de 60 mV/dec d'un paramètre SS (SS pour « subthreshold swing ») avec SS = ∂V_{GS}/∂I_{D} (V_{GS} étant la tension entre l'électrode de grille et l'électrode de source) est représenté (droite L'₀).

Un courant de conduction I_{ON} > 1×10⁻³ A/µm à l'état passant peut être obtenu pour un potentiel de grille V_{G} = -1.2V et un potentiel de drain V_{D} = -1V.

Sur la figure 9, une courbe C₁₀ représentative du paramètre SS (SS pour « subthreshold swing ») avec SS = ∂V_{GS}/∂I_{D} (V_{GS} étant la tension entre l'électrode de grille et l'électrode de source) en fonction du courant de drain I_{D} du transistor pour un potentiel V_{D} = -1V. Un paramètre SS inférieur à 60 mV/dec peut être ainsi obtenu pour I_{D} compris entre 10⁻¹³ A/µm et 10⁻⁶ A/µm, ce paramètre SS pouvant même atteindre des valeurs inférieures à 25 mV/dec. A titre de comparaison, une courbe C'₁₀ représentative du paramètre SS pour un transistor TFET suivant l'art antérieur est donnée. Une droite L'₁₀ représente quant à elle le seuil SS de 60 mV/dec.

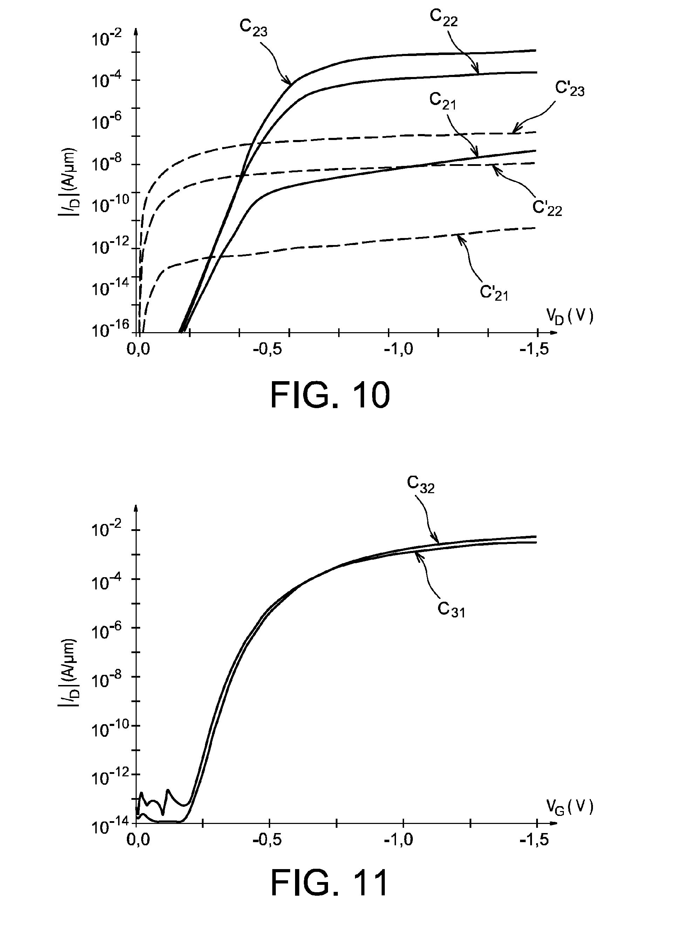

La figure 10 donne des courbes C₂₁, C₂₂, C₂₃, (en traits continus) d'évolution de courant de drain en fonction d'un potentiel de drain du transistor à potentiel de grille V_{G} constant, avec V_{G} = -0.5V pour la première courbe C₂₁, V_{G} = -1V pour la deuxième courbe C₂₂ et avec V_{G} = -1.5V pour la troisième courbe C₂₃. A titre de comparaison, des courbes C'₂₁, C'₂₂, C'₂₃, (en traits discontinus) d'évolution de courant de drain d'un transistor TFET suivant l'art antérieur, respectivement pour un potentiel de grille de -0.5V, un potentiel de grille de -1V, et un potentiel de grille de -1.5V sont données.

Pour améliorer le courant de drain I_{D}, il est possible de doper davantage la deuxième zone dopée 112 ou de prévoir une couche tunnel à base d'un matériau semi-conducteur de type III-V sous la grille du transistor.

La figure 11 donne des courbes C₃₁, C₃₂, représentatives d'évolution de courant de drain en fonction du potentiel de grille V_{G} à potentiel de drain constant et égal à -1.5V, respectivement pour une grille de longueur L_{G} = 25 nm et une grille de longueur L_{G} = 50 nm. Ces courbes montrent que les performances en termes de courant de drain du dispositif sont maintenues, même avec des dimensions, en particulier de longueur de grille très réduites.

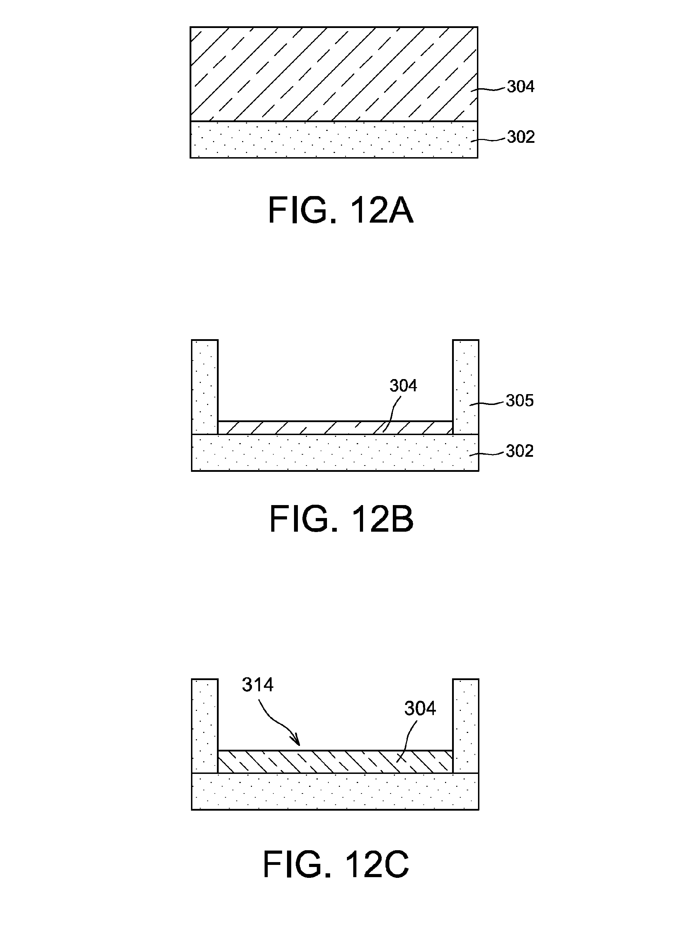

Un exemple de procédé de réalisation d'un transistor suivant l'invention, et du type de celui décrit précédemment en liaison avec la figure 6, va à présent être donné (figures 12A-12H).

Le matériau de départ de ce procédé peut être un substrat de type semi-conducteur sur isolant, formé d'un support semi-conducteur (non représenté), par exemple à base de silicium, recouvert d'une couche isolante 302, par exemple à base de SiO₂, elle-même recouverte d'une couche semi-conductrice 304, par exemple à base de Si (figure 12A).

Dans la couche semi conductrice 304, on forme des zones d'isolation 305 qui peuvent être de type STI (STI pour « shallow trench isolation ») et formées à l'aide d'étapes de photolithographie, de gravure et d'oxydation. Une partie de l'épaisseur de la couche semi conductrice 304 peut être ensuite retirée dans une zone située entre les zones d'isolation 305 (figure 12B).

Puis, un dopage de la couche 304 par exemple de type N+ est effectué afin de former une zone dopée 314 de la région de source enterrée. Ce dopage peut être réalisé par exemple par implantation à l'aide d'arsenic ou de phosophore (figure 12C).

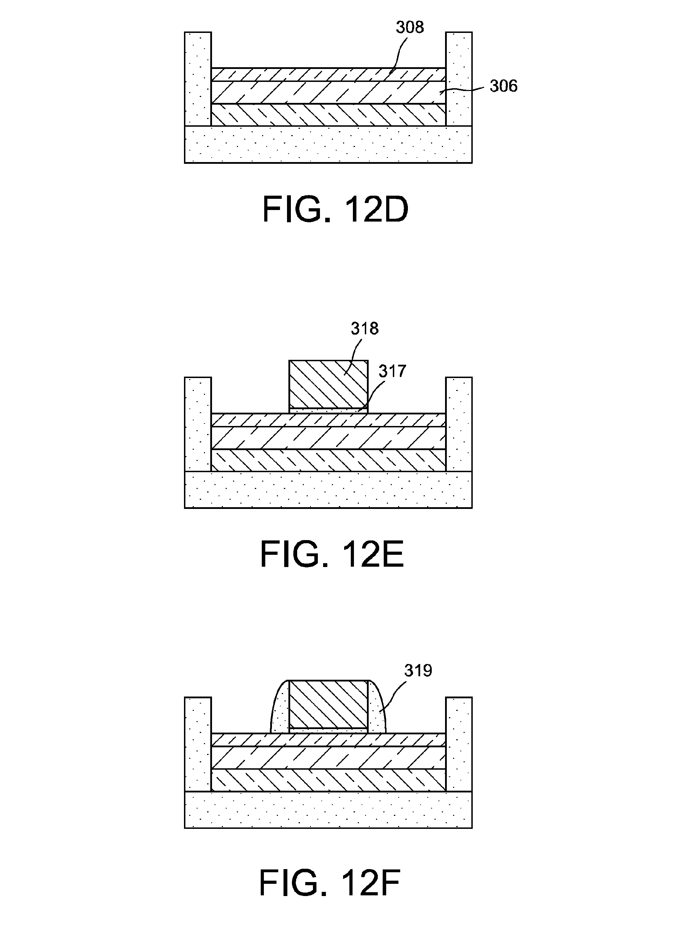

Puis, on forme sur la couche semi conductrice 304 dopée N+, une couche tampon 306, par exemple à base de Si, sur laquelle une couche semi-conductrice tunnel 308, par exemple à base de Si₁₋ₓGeₓ, est réalisée. Les couches semi-conductrices 306, 308 peuvent être réalisées par exemple par épitaxie (figure 12D).

Ensuite, on forme un empilement de grille, par exemple par dépôt ALD (ALD pour « Atomic Layer Deposition ») ou oxydation du matériau semiconducteur du canal afin de réaliser un diélectrique 317 de grille, puis dépôt de type PVD (« physical vapor deposition ») ou CVD (« chemical vapor deposition ») d'un matériau 317 de grille, par exemple formé d'un empilement de métal et de polysilicium. Ces étapes peuvent être suivies d'étapes de photolithographie et de gravure de manière à former un motif de grille (figure 12E).

On réalise ensuite des espaceurs isolants de part et d'autre de la grille, par exemple par dépôt puis gravure d'un matériau diélectrique 319, par exemple du nitrure de silicium (figure 12F).

Selon une possibilité (non représentée), les espaceurs isolants peuvent être formés d'un empilement de plusieurs couches.

On forme ensuite des régions de source et de drain.

Cela peut être réalisé par formation d'une zone semi-conductrice dopée P, par exemple à base de Si₁₋ₓGeₓ d'un côté de la grille du transistor suivi d'une formation d'une autre zone semi-conductrice dopée N+ par exemple à base silicium, de part et d'autre de la grille du transistor, la zone dopée N+ recouvrant la zone dopée P du côté de la région de drain.

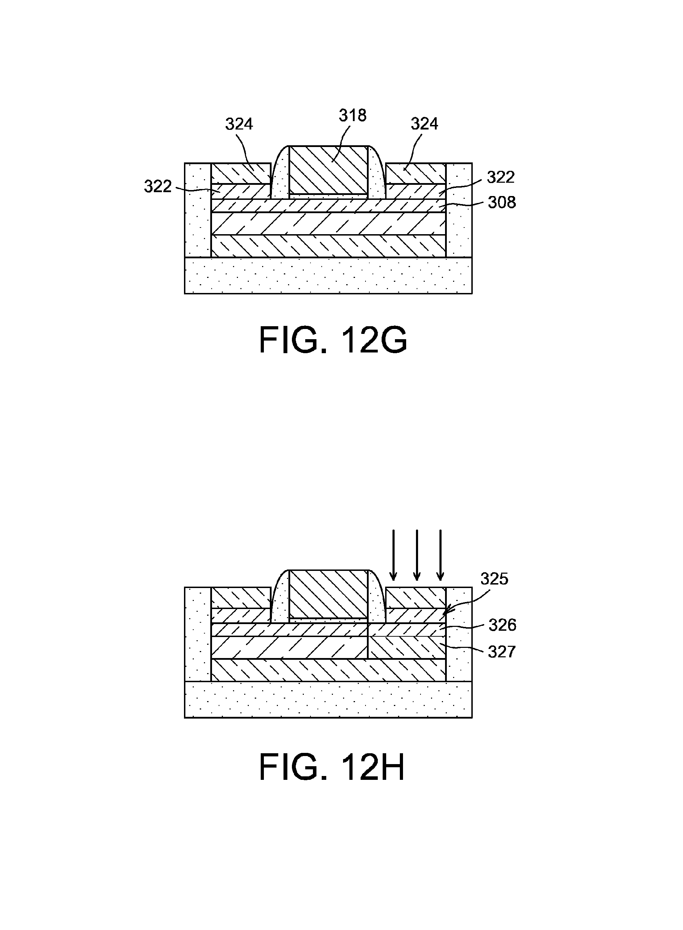

Selon une variante (figure 12G) utilisant moins d'étapes, on forme tout d'abord sur la couche tunnel 308, une couche semi-conductrice 322 dopée P, par exemple à base de Si₁₋ₓGeₓ de part et d'autre de la grille 318 du transistor, puis on forme une autre couche semi-conductrice 324 dopée N+ sur cette couche semi-conductrice 322 dopée P (figure 12G).

On effectue ensuite (figure 12H) un dopage localisé, en particulier une implantation localisée, d'un seul côté de la grille, le côté implanté correspondant à celui de la région de source du transistor afin de transformer la couche semi-conductrice 322 dopée P à base de Si₁₋ₓGeₓ en une zone dopée N+ du côté de la région de source.

Lors de cette étape d'implantation un dopage de type N+ d'une zone 326 de la couche tunnel 308 et d'une zone 327 de la couche tampon 306 situées du côté de la région de source sont également effectués. Le procédé qui vient d'être décrit peut être également adapté sur un substrat différent d'un substrat SOI, par exemple sur un substrat massif (« bulk ») de Si ou sur un substrat semi-conducteur à base de matériau III-V.

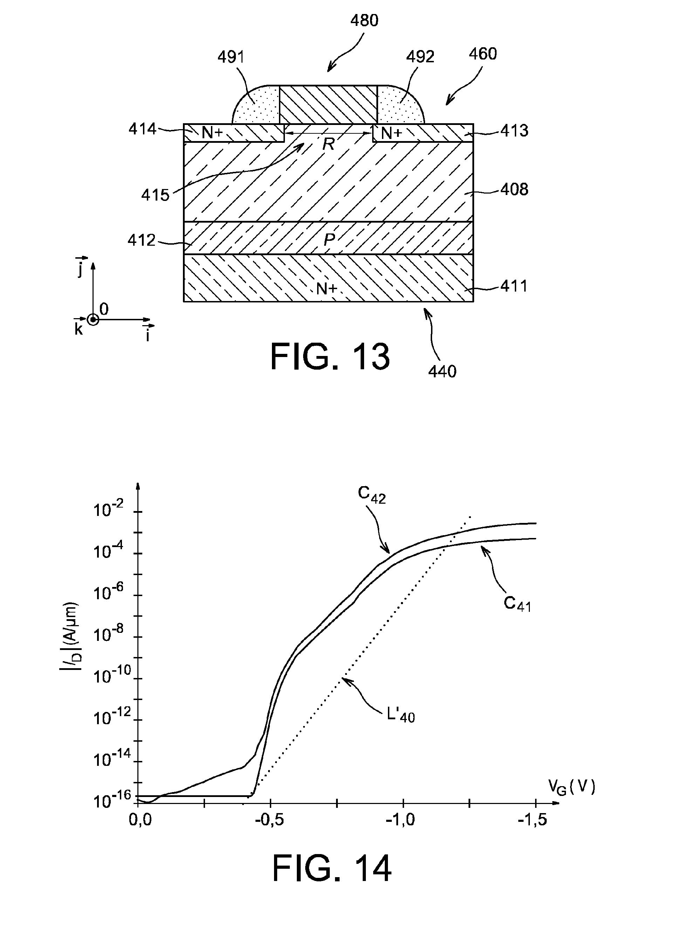

Un quatrième exemple de transistor suivant l'invention est illustré sur la figure 13 et comporte une région de drain, une région de canal, et une région de grille superposées.

La région de drain 440 comporte une première zone 411 dopée selon un dopage d'un premier type, par exemple de type N+ surmontée d'une deuxième zone 412 dopée selon un dopage d'un deuxième type, différent du premier type, par exemple de type P. La première zone dopée N+ 411 peut être avantageusement formée d'une couche semi-conductrice, par exemple à base de silicium, tandis que la deuxième zone dopée 412 est formée d'une autre couche semi-conductrice, par exemple à base de Si₁₋ₓGeₓ, sur et en contact avec la couche de Si.

La première zone dopée 411 et la deuxième zone dopée forment ainsi une jonction N+P surmontée d'une couche semi-conductrice tampon 408 dans laquelle une région de canal du transistor est prévue et sur laquelle repose un diélectrique de grille et une électrode de grille 480.

De part et d'autre de la grille 480, des zones 413 et 414, dopées selon le dopage du même type, que celui de la première zone 411, par exemple un dopage N+, forment une région de source agencée de part et d'autre de la grille 480. Ces zones dopées 413, 414 s'étendent sous des espaceurs 491, 492 formés contre la grille 480 et peuvent être séparées l'une de l'autre par une région semi-conductrice 415 faiblement dopée ou non-dopée qui peut appartenir à la couche semi-conductrice 408.

La longueur R ou dimension critique R (R étant dans cet exemple une dimension mesurée dans une direction parallèle au vecteur *̅i̅*̅ du repère orthogonal [o; *̅i̅*̅; *̅j̅*̅; *̅k̅*̅] donné sur la figure 11) de la région 415 de la couche 408 séparant ces zones dopées 413 et 414 peut être comprise par exemple entre 20 nm et 1 micron par exemple de l'ordre de 50 nm.

La couche tampon 408 en contact avec une deuxième zone dopée 412, est par exemple à base de silicium tandis que les zones dopées 413 et 414 sont par exemple à base de SiGe.

Des conditions de polarisation telles qu'un potentiel de source V_{S} = 0V est appliqué aux zones dopées 413 et 414, qu'un potentiel V_{G} inférieur à 0V est appliqué sur la grille 480, et qu'un potentiel de drain V_{D} inférieur à 0V est appliqué à la zone dopée 411 dopée N+, peuvent être par exemple prévues.

Un tel transistor peut avoir un courant I_{ON} à l'état passant supérieur à 1×10⁻³ A/µm pour un potentiel de grille |VG| = 1,2 V et un potentiel de drain |VD| = 1V.

La figure 14 illustre des performances électriques d'un tel transistor, conçu avec des zones dopées 413 et 414 espacées d'une longueur R de 50 nm.

Sur cette figure, des courbes C₄₁, C₄₂ sont représentatives du paramètre SS de ce transistor pour un potentiel de drain V_{D} = -1V, et pour un potentiel de drain V_{D} =-1.5V. Une ligne L'₄₀ marque une limite de 60 mV/dec du paramètre SS, l'inverse de la pente sous seuil caractéristique pour un transistor standard.

Avec un transistor tel que mis en oeuvre sur la figure 13, un paramètre SS inférieur à 60 mV/dec peut être obtenu pour une gamme importante de courant de drain, et en particulier plus importante que pour un transistor tunnel de l'art antérieur.

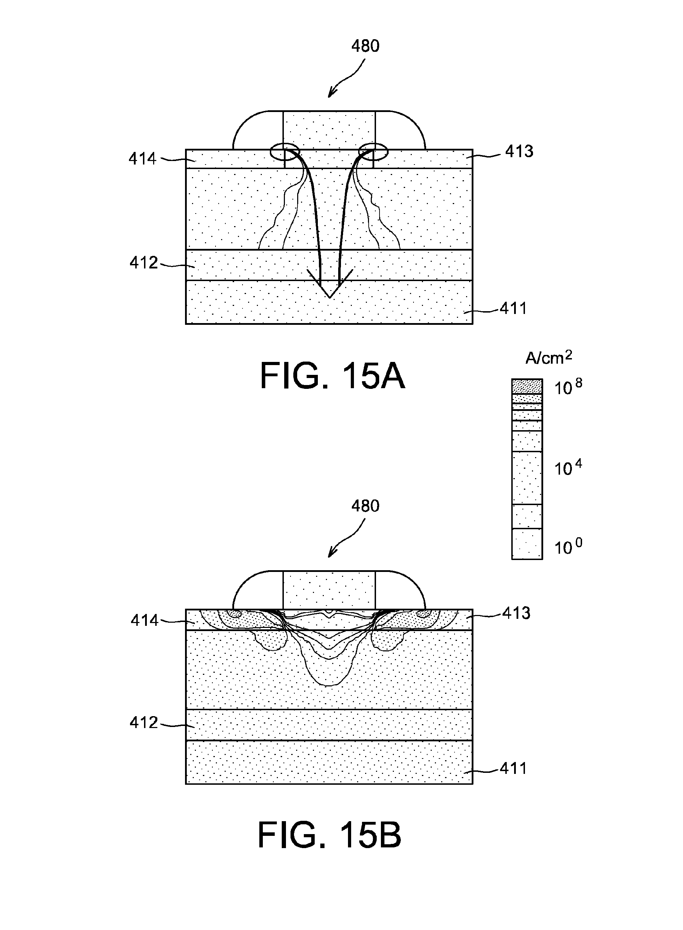

La figure 15A représente une densité de trous au sein d'un transistor à effet tunnel tel que décrit précédemment, pour des conditions de polarisation telles que le potentiel de drain V_{D} = -1.5V, le potentiel de grille V_{G} = -2V, le potentiel de source V_{S}= 0V.

La figure 15B représente quant à elle une densité d'électrons au sein de ce transistor.

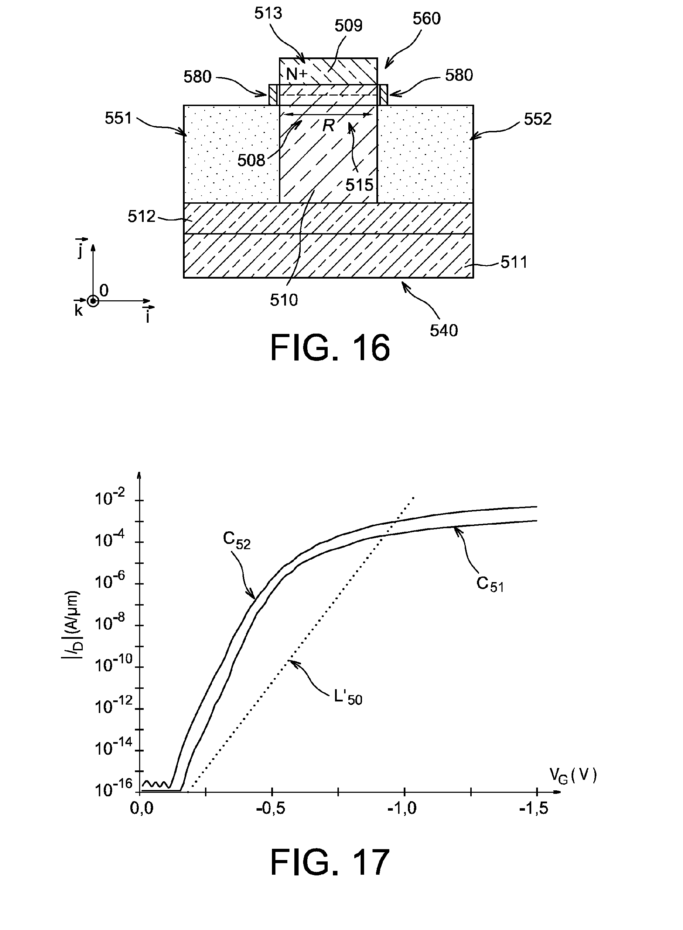

La figure 16 illustre un cinquième exemple de transistor, dans lequel les régions de drain 540, de canal et de source 560 sont superposées. La région de drain 540 forme une jonction N+P, sur laquelle une zone 515 non-dopée ou faiblement dopée est disposée, cette zone 515 non-dopée ou faiblement dopée étant surmontée par la région de source 560.

La région de source 560 de ce transistor est formée d'une zone dopée 513 dopée selon un dopage d'un premier type, par exemple de type N+, formée dans une couche semi-conductrice 509 par exemple à base de Si et repose sur un bloc semi-conducteur 508 tunnel, par exemple à base de Si₁₋ₓGeₓ. La zone dopée 513 se prolonge dans la partie supérieure du bloc semi-conducteur 508 tunnel également dopée N+, la partie inférieure du bloc semi-conducteur 508 tunnel étant quant à elle non dopée ou faiblement dopée.

Une électrode de grille 580 est formée autour ou de part et d'autre du bloc semi-conducteur 508 tunnel contre des flancs latéraux de ce bloc, lequel repose sur un autre bloc semi-conducteur 510 non-dopé, par exemple à base de Si, entourée de blocs isolants 551, 552, par exemple à base de Si₃N₄.

Dans cet exemple, une portion de la grille est située en regard d'une portion de la zone dopée 513 située dans la partie supérieure du bloc semi-conducteur 508. Cette disposition de la grille en regard de la zone N⁺ 560 permet de maximiser le champ électrique permettant d'augmenter l'effet tunnel.

Les blocs semi-conducteurs 508, 510 peuvent avoir une longueur R₂ ou dimension critique R₂ (R₂ étant ici une dimension mesurée dans une direction parallèle au vecteur *̅i̅*̅ du repère orthogonal [o; *̅i̅*̅; *̅j̅*̅; *̅k̅*̅] donné sur la figure 16) par exemple comprise entre 20 nm et 1 micron ou de l'ordre de 50 nm.

Le bloc semi-conducteur 510 non-dopé et les blocs isolants 551, 552 formés de part et d'autre de ce dernier reposent sur une zone semi-conductrice 512 dopée selon un dopage de type différent de celui de la zone 513, par exemple un dopage de type P. La deuxième zone dopée 512 repose sur une autre zone dopée 511 et formant avec cette dernière une jonction. Cette autre zone dopée 511 peut être dopée N+ et par exemple à base de Si.

Des conditions de polarisation telles qu'un potentiel de source V_{S} = 0V est appliqué, un potentiel V_{G} inférieur à 0V est appliqué à la grille 580, et qu'un potentiel de drain V_{D} inférieur à 0V est appliqué à la zone dopée 511 dopée N+, peuvent être par exemple prévues.

La figure 17 illustre des performances électriques d'un tel transistor. Sur cette figure, des courbes C₅₁, C₅₂ sont représentatives du courant de drain I_{D} en fonction du potentiel V_{G} appliqué à la grille respectivement pour un potentiel de drain V_{D} = -1V, et pour un potentiel de drain V_{D} =-1.5V. Une ligne L'₅₀ marque une limite de 60 mV/dec.

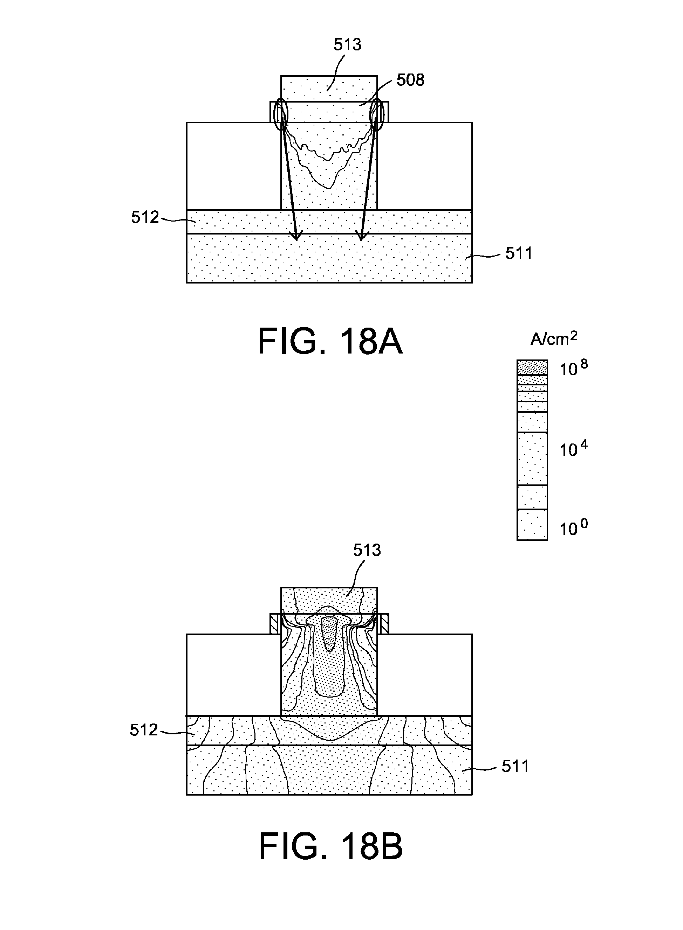

La figure 18A représente une densité de trous au sein d'un transistor à effet tunnel tel que décrit précédemment en liaison avec la figure 16, pour des conditions de polarisation avec un potentiel de drain V_{D} = -1.5V, un potentiel de grille V_{G} = -2V, un potentiel de source V_{S} = 0V.

La figure 18B représente quant à elle une densité d'électrons au sein de ce transistor.

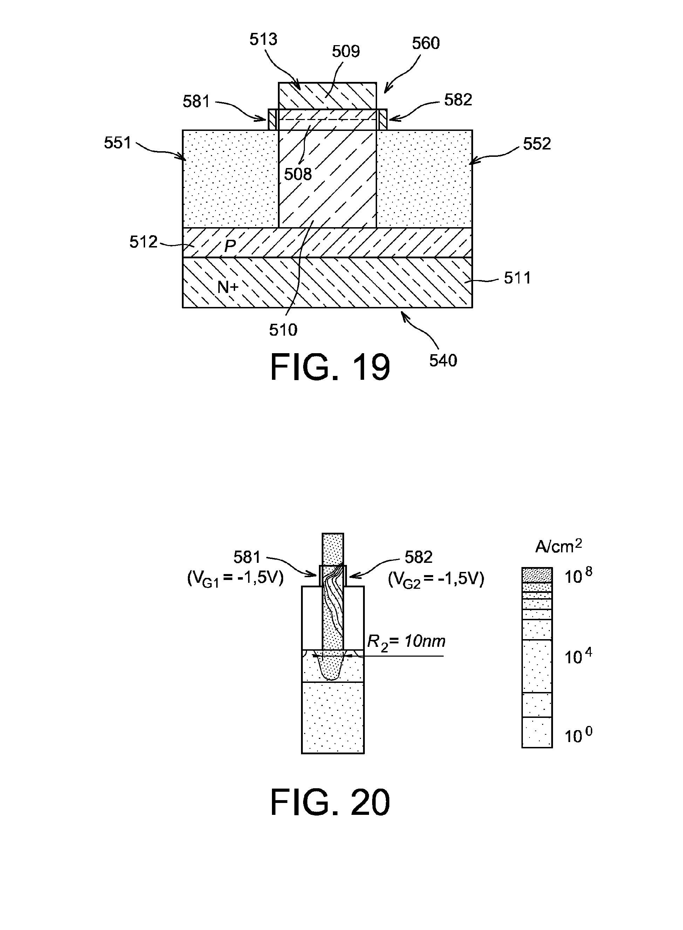

La figure 19 illustre un sixième exemple de transistor tunnel à amplification bipolaire mis en oeuvre suivant l'invention.

Ce transistor diffère de l'exemple précédemment décrit, en ce qu'il comporte une première électrode de grille 581, et une deuxième électrode de grille 582, ces électrodes de grilles étant indépendantes et n'étant pas connectées entre elles.

Les électrodes de grilles 581, 582 sont disposées de part et d'autre du bloc semi-conducteur 508 tunnel contre des flancs latéraux de ce bloc, et peuvent être ainsi polarisées indépendamment l'une de l'autre. Dans cet exemple, une portion des grilles 581, 582 est située en regard d'une portion de la zone dopée 513 située dans la partie supérieure du bloc semi-conducteur 508. Cette disposition en regard de la zone N⁺ 560 permet de maximiser le champ électrique permettant d'augmenter l'effet tunnel.

La première électrode de grille 581, peut être polarisée à l'aide d'un potentiel V_{G1} > 0 V afin d'améliorer le flux vertical d'électrons, tandis que la deuxième électrode de grille 582, peut être polarisée à l'aide d'un potentiel V_{G2} < 0 V afin d'augmenter l'effet tunnel.

Un tel agencement avec deux grilles indépendantes, c'est-à-dire susceptibles d'être polarisées indépendamment l'une de l'autre, peut avantageusement permettre de mettre en oeuvre un transistor dans lequel la longueur R₂ encore appelée dimension critique R₂ du bloc semi-conducteur 510 jusqu'à une valeur par exemple de l'ordre de 10 nm.

La figure 20 représente quant à elle une densité d'électrons au sein d'un tel transistor lorsque la première électrode de grille 581 est polarisée à un potentiel V_{G1} de sorte que V_{G1} = 1.5V et lorsque la deuxième électrode de grille 582 est polarisée à un potentiel V_{G2} de sorte que grille V_{G2} = -1.5V.

## Revendications

1. Transistor à effet tunnel comprenant des régions de source (160, 460, 560) et de drain (140, 440, 540) et une électrode de grille (180, 480, 580, 581), une région donnée (140, 440, 540) parmi lesdites régions de source et de drain comportant une première zone semi-conductrice dopée (111, 411, 511) selon un dopage d'un premier type, dans lequel ladite région donnée (140, 440, 540) comporte en outre une deuxième zone semi-conductrice dopée (112, 412, 512) selon un dopage d'un deuxième type et formant une jonction avec ladite première zone semi-conductrice dopée, l'autre région (160, 460, 560), parmi les régions de source et de drain comportant une troisième zone semi-conductrice dopée (113, 413, 513) selon un dopage du premier type.

2. Transistor à effet tunnel selon la revendication 1, ladite deuxième zone semi-conductrice dopée (112, 412, 512) et ladite troisième zone semi-conductrice dopée (113, 413, 513) étant séparées par une zone semi-conductrice (115, 415, 515) non-dopée ou faiblement dopée dans laquelle une région de canal est prévue.

3. Transistor selon la revendication 1 ou 2, la première zone semi-conductrice dopée (111, 411, 511) et la deuxième zone semi-conductrice (112, 412, 512) étant superposées ou empilées.

4. Transistor selon l'une des revendications 1 à 3, comprenant en outre : un premier espaceur isolant (191) et un deuxième espaceur isolant (192) disposés contre l'électrode de grille (180), la troisième zone dopée s'étendant sous le deuxième espaceur (192), ladite zone semi-conductrice non-dopée (115) ou faiblement dopée étant en contact avec ladite deuxième zone (112) semi-conductrice dopée, et disposée en regard de la grille ainsi que sous le premier espaceur (191).

5. Transistor selon l'une des revendications 1 à 4, dans lequel ladite autre région, parmi les régions de source et de drain comporte une quatrième zone semi-conductrice dopée (114) ayant un dopage du premier type, la quatrième zone semi-conductrice dopée (114) étant en contact électrique avec la troisième zone semi-conductrice dopée (113) et disposée en regard de ladite région de canal et de ladite région donnée (140), ladite zone semi-conductrice (115) non-dopée ou faiblement dopée séparant ladite quatrième zone semi-conductrice dopée de ladite deuxième zone (112) semi-conductrice dopée.

6. Transistor selon la revendication 1, dans lequel la première zone semi-conductrice dopée (411) et la deuxième zone semi-conductrice dopée (412) sont superposées, les régions de drain (440) et de source (460) étant également superposées, ladite autre région (460) comportant, de part et d'autre de l'électrode de grille (480), la troisième zone semi-conductrice dopée (413) et une quatrième zone semi-conductrice (414) dopée selon un dopage du premier type, la quatrième zone semi-conductrice (414) dopée et ladite troisième zone semi-conductrice dopée reposant sur une zone semi-conductrice non-dopée ou faiblement dopée et étant séparés de la deuxième zone semi-conductrice dopée par ladite zone semi-conductrice non-dopée ou faiblement dopée.

7. Transistor selon la revendication 1, dans lequel la première zone semi-conductrice dopée (511) et la deuxième zone semi-conductrice dopée (512) sont superposées, les régions de drain (540) et de source (560) étant également superposées, une zone semi-conductrice non-dopée (515) reposant sur ladite deuxième zone semi-conductrice dopée (512) et séparant ladite deuxième zone semi-conductrice dopée (513) de ladite troisième zone semi-conductrice dopée (513), ladite troisième zone semi-conductrice dopée (513) reposant sur la zone semi-conductrice non-dopée (515) ou faiblement dopée, l'électrode de grille étant disposée autour d'une portion de ladite zone semi-conductrice non-dopée (508).

8. Transistor selon la revendication 1, dans lequel la première zone semi-conductrice dopée (511) et la deuxième zone semi-conductrice dopée (512) sont superposées, les régions de drain (540) et de source (560) étant également superposées, une zone semi-conductrice non-dopée (515) reposant sur ladite deuxième zone semi-conductrice dopée (512) et séparant ladite deuxième zone semi-conductrice dopée (513) de ladite troisième zone semi-conductrice dopée (513), ladite troisième zone semi-conductrice dopée (513) reposant sur la zone semi-conductrice non-dopée (515) ou faiblement dopée,
ladite électrode de grille (581) étant disposée contre une première portion de ladite zone semi-conductrice non-dopée (508), le transistor comprenant en outre une autre électrode de grille (582) indépendante ladite électrode de grille (581) et qui est disposée contre une autre portion de ladite zone semi-conductrice non-dopée (508), en regard de ladite première portion.

9. Transistor selon l'une des revendications 1 à 8, dans lequel la première zone semi-conductrice dopée (111, 411, 511) est à base d'un premier matériau semi-conducteur, et dans lequel la deuxième zone semi-conductrice dopée (112, 412, 512) est à base d'un deuxième matériau semi-conducteur le deuxième matériau semi-conducteur ayant un gap plus faible que le premier matériau semi-conducteur.

10. Transistor selon la revendication 9, dans lequel l'électrode de grille et la deuxième zone semi-conductrice dopée reposent sur une couche à base du deuxième matériau semi-conducteur.

11. Dispositif microélectronique comprenant un ou plusieurs transistors selon l'une des revendications 1 à 10.

12. Procédé de réalisation d'un transistor à effet tunnel comprenant des étapes de : formation d'une région donnée de source ou de drain (140, 440, 540) comportant une zone semi-conductrice dopée (111, 411, 511) selon un dopage d'un premier type reposant sur une deuxième zone semi-conductrice dopée (112, 412, 512) selon un dopage d'un deuxième type et réalisant une jonction avec ladite première zone semi-conductrice dopée, et d'une autre région (160, 460, 560), parmi les régions de source et de drain comportant une troisième zone semi-conductrice dopée (113, 413, 513) selon un dopage de type différent de celui de ladite deuxième zone dopée.

13. Procédé de réalisation d'un transistor selon la revendication 12 comprenant préalablement à l'étape de formation de ladite région donnée, des étapes de :
- formation au moins partielle d'une électrode de grille, puis
- formation de la région donnée (140) par dépôt de part et d'autre de la grille d'une couche semi-conductrice dopée selon le dopage du deuxième type, puis dépôt de part et d'autre de la grille d'une autre couche semi-conductrice dopée selon le dopage du premier type.

14. Procédé de réalisation d'un transistor selon la revendication 13 comprenant après l'étape de formation de la région donnée, une étape consistant à implanter localement d'un seul côté de l'électrode de grille de manière à modifier le dopage de ladite couche semi-conductrice dopée et de ladite autre couche semi-conductrice dopée, ladite couche semi-conductrice devant dopée selon un dopage du premier type.
